(19) **Europäisches Patentamt / European Patent Office / Office européen des brevets**

(11) **EP 3 248 212 B1**

(12) **FASCICULE DE BREVET EUROPEEN**

(45) Date de publication et mention de la délivrance du brevet:
**18.08.2021   Bulletin 2021/33**

(51) Int Cl.:
***H01L 21/02*** *(2006.01)*

(21) Numéro de dépôt: **16705569.8**

(22) Date de dépôt: **21.01.2016**

(86) Numéro de dépôt international:
**PCT/FR2016/050124**

(87) Numéro de publication internationale:
**WO 2016/116713 (28.07.2016 Gazette 2016/30)**

(54) **PROCÉDÉ DE FABRICATION D'UNE STRUCTURE SEMI-CONDUCTRICE À BASE DE NITRURES D'ÉLÉMENTS III PASSIVÉE ET UNE TELLE STRUCTURE**

VERFAHREN ZUR HERSTELLUNG EINER PASSIVIERTEN HALBLEITERSTRUKTUR AUF BASIS VON GRUPPE-III-NITRIDEN UND EINE DERARTIGE STRUKTUR

METHOD FOR PRODUCING A PASSIVATED SEMICONDUCTOR STRUCTURE BASED ON GROUP III NITRIDES, AND ONE SUCH STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.01.2015   FR 1550461**

(43) Date de publication de la demande:
**29.11.2017   Bulletin 2017/48**

(73) Titulaire: **Centre National de la Recherche Scientifique (C.N.R.S.)**
**75016 Paris (FR)**

(72) Inventeurs:
• **SEMOND, Fabrice**
  **06400 Cannes (FR)**
• **FRAYSSINET, Eric**
  **06370 Mouans Sartoux (FR)**
• **MASSIES, Jean**
  **06560 Valbonne (FR)**

(74) Mandataire: **Marks & Clerk France**
**Immeuble "Visium"**
**22, avenue Aristide Briand**
**94117 Arcueil Cedex (FR)**

(56) Documents cités:
**US-A1- 2006 240 584**

• **DERLUYN J ET AL: "Improvement of AlGaN/GaN high electron mobility transistor structures by in situ deposition of a Si3N4 surface layer", JOURNAL OF APPLIED PHYSICS, AMERICAN INSTITUTE OF PHYSICS, US, vol. 98, no. 5, 2 septembre 2005 (2005-09-02), pages 54501-054501, XP012078530, ISSN: 0021-8979, DOI: 10.1063/1.2008388**
• **LEBEDEV V ET AL: "The role of Si as surfactant and donor in molecular-beam epitaxy of AlN", JOURNAL OF APPLIED PHYSICS, AMERICAN INSTITUTE OF PHYSICS, US, vol. 98, no. 9, 4 November 2005 (2005-11-04), pages 93508-093508, XP012078893, ISSN: 0021-8979, DOI: 10.1063/1.2126786**

## Description

### DOMAINE DE L'INVENTION

L'invention concerne un procédé de fabrication d'une structure semi-conductrice à base de nitrures d'éléments III et une telle structure semi-conductrice.

### PRESENTATION DE L'ART ANTERIEUR

Les matériaux semi-conducteurs à base de nitrures d'éléments III du tableau périodique - tels que les matériaux à base de nitrure de gallium GaN - occupent une place de plus en plus importante dans les domaines de l'électronique et de l'optoélectronique, notamment pour la fabrication de diodes électroluminescentes.

Les procédés existants de fabrication d'une structure semi-conductrice à base de nitrures d'éléments III, tel que le nitrure de gallium GaN sur un substrat, par exemple en silicium ou en saphir, résultent généralement en une densité de dislocations traversantes importante liée à la différence de paramètre de maille entre le substrat hôte et les matériaux semi-conducteurs à base de nitrures d'éléments III. Ces dislocations traversantes sont particulièrement pénalisantes dans le cas de structures semi-conductrices formant des dispositifs d'émission de lumière à base de matériaux semi-conducteurs de nitrures d'éléments III puisque les dislocations traversantes augmentent les courants de fuites et détériorent le rendement de luminescence de ces dispositifs d'émission de lumière.

Les techniques d'épitaxie tridimensionnelle - telles que la surcroissance latérale (ELO de l'anglais « epitaxial lateral overgrowth »), la pendeo-épitaxie à partir de nano-piliers, l'ajout d'espèces antisurfactantes, la modification des conditions de croissance - ont prouvé leur efficacité pour réduire la densité de dislocations traversantes dans les matériaux semi-conducteurs à base de nitrures d'éléments III. L'approche utilisée par ces techniques pour réduire la densité de dislocations traversantes consiste à initier un mode de croissance tridimensionnelle (par îlot), puis à favoriser la coalescence des îlots pour obtenir une couche bidimensionnelle de nitrure gallium GaN.

Une technique in-situ populaire pour réduire la densité de dislocations traversantes consiste à insérer une couche intercalaire de nitrure de silicium SiNx en dessous de la couche de GaN. Plus précisément, une couche de nitrure de silicium SiNx est déposée in-situ sur une couche de nitrure d'élément III, puis une couche de nitrure de gallium GaN est déposée sur la couche de nitrure de silicium SiNx. Cette technique a prouvé son efficacité pour réduire la densité de dislocations traversantes pour le GaN plan-c conventionnel mais aussi pour les orientations semi-non polaires.

Il est reconnu qu'un traitement de surface à base de silicium et d'ammoniac conduit à la formation d'une couche nano-poreuse de nitrure de silicium SiNx qui agit comme un nano-masque permettant d'initier un mode de croissance tridimensionnelle du GaN. La croissance de GaN est inhibée dans les régions où se trouve le nitrure de silicium SiNx. En revanche la croissance se produit dans les nano-pores, c'est-à-dire dans les ouvertures du nano-masque. La densité et la taille de ces derniers sont contrôlées par le temps de dépôt du nitrure de silicium SiNx et leur répartition à la surface est aléatoire.

Par exemple, les documents suivants traitent de ces sujets :

- L'article intitulé "A New Method of Reducing Dislocation Density in GaN Layer Grown on Sapphire Substrate by MOVPE" par Sakai et al., J. Cryst. Growth, 221, 334 (2000),
- l'article intitulé "Anti-Surfactant in III-Nitride Epitaxy - Quantum Dot Formation and Dislocation Termination" par S. Tanaka et al., Jap. J. Appl. Phys., 39, L83 1 (2000),
- l'article "Efficacy of single and double SiNx interlayers on defect reduction in GaN overlayers grown by organometallic vapor-phase epitaxy", par F. Yun et al., J. Appl. Phys., 98, 123502 (2005),
- la demande de brevet DE10151092 A1,
- la demande de brevet WO2007/133603 A2.

Il a récemment été montré que ce type de traitement pouvait aussi conduire à la formation d'une structure cristalline notée $3^{1/2}$x$3^{1/2}$ R30°, notamment dans l'article "Blocking Growth by Electrically Active Subsurface Layer : The Effects of Si as an Antisurfactant in the Growth of GaN", par T. Markurt et al. Physical Review Letters 110, 036103 (2013). Dans cet article, la couche cristalline est fabriquée de façon à obtenir une surface partiellement recouverte, avec des régions plus ou moins grandes non recouvertes que l'on appelle « ouvertures » et cette couche est dite « nanoporeuse ».

Lors de l'étape de dépôt de la couche de nitrure de gallium GaN, le nitrure de gallium épitaxié croît préférentiellement dans les ouvertures de la couche nanoporeuse de sorte à former des îlots. Une fois les îlots formés, les paramètres de croissance sont ajustés pour que le nitrure de gallium GaN se développe latéralement de sorte à recouvrir les zones couvertes de SiNx, et coalescent afin de former une couche de nitrure de gallium GaN (croissance 3D). La croissance de la couche de nitrure de gallium est ensuite poursuivie jusqu'à l'obtention d'une épaisseur de nitrure de gallium GaN désirée (croissance 2D). L'épaisseur de coalescence du nitrure de gallium GaN est définie comme l'épaisseur requise pour obtenir une couche de GaN entièrement coalescée après l'insertion de la couche de SiNx.

Le lecteur aura compris que l'augmentation de la durée du traitement de surface, et donc de la quantité de SiNx déposé, a pour effet d'augmenter le taux de couverture de la couche SiNx et donc de diminuer la densité d'îlots de nitrure de gallium GaN, ce qui permet de diminuer la densité de dislocations traversantes. En revanche, plus la densité d'îlots de nitrure de gallium GaN est faible, plus l'épaisseur de de niture de gallium GaN requise pour obtenir la coalescence est importante. Il est donc particulièrement avantageux de déterminer le taux de couverture optimum de la couche de SiNx pour rendre un tel procédé exploitable industriellement.

De plus, les procédés existants de fabrication de dispositifs à base de GaN sur un substrat comprennent généralement une première étape de dépôt d'une couche tampon, laquelle peut être par exemple du nitrure d'aluminium AlN pour un substrat silicum éventuellement suivie d'une étape de dépôt d'une couche de nitrure d'aluminium et gallium AlGaN sur la couche tampon de nitrure d'aluminium AlN. Le nano-masque peut ensuite être déposé sur la couche d'AlN ou d'AlGaN. D'autres procédés prévoient d'utiliser un substrat saphir et de déposer une couche de GaN à basse température en tant que couche tampon, auquel cas le nano-masque est déposé sur la couche tampon de GaN.

Un inconvénient de la technique de croissance avec le nano-masque de SiNx évoquée concerne le fait que des réactions d'oxydation peuvent avoir lieu à la surface de la couche tampon non recouverte par la couche de SiNx. Notamment, la couche tampon peut s'oxyder au niveau des ouvertures en cas d'exposition à l'air du support constitué du substrat, de la couche tampon et de la couche de SiNx. Par conséquent, dans les procédés de l'état de la technique, la couche de nitrure de gallium GaN supérieure (ou finale) est formée sur la couche SiNx immédiatement après la formation de celle-ci, sans possibilité de stockage du support préalablement au dépôt d'une couche de nitrure de gallium sur celui-ci.

Un autre inconvénient de cette technique concerne le fait qu'il n'existe aucun moyen permettant de définir la durée optimale de l'étape de dépôt de la couche nanoporeuse de SiNx. Cette durée optimale, liée à la taille des ouvertures et leur densité, varie en fonction du substrat de départ utilisé pour la croissance, du type de réacteur utilisé pour la croissance, et d'autres paramètres tels que les concentrations en précurseurs gazeux etc. La taille des ouvertures et leur densité sont des quantités non mesurables donc la détermination de la durée optimale de l'étape de dépôt de la couche nanoporeuse de SiNx ne peut donc être obtenue que de manière empirique en réalisant des essais successifs qui doivent être réitérés à chaque fois que l'un des paramètres de croissance (i.e. substrat, réacteur, etc.) est modifié, ce qui est coûteux en temps et surtout ne permet pas de réaliser un procédé générique, c'est-à-dire applicable de façon générale.

Un but de la présente invention est de proposer un procédé permettant de pallier au moins l'un des inconvénients précités.

## RESUME DE L'INVENTION

A cet effet, l'invention propose un procédé de fabrication d'une structure semi-conductrice passivée formant support pour une structure à base de nitrures d'éléments III, selon la revendication 1.

Le fait de déposer une couche cristalline qui recouvre la totalité de la surface d'une couche à base de nitrures d'éléments III de la structure semi-conductrice permet de passiver totalement la surface de cette couche à base de nitrures d'éléments III et donc d'empêcher toute réaction d'oxydation de cette dernière. Ceci rend possible le stockage de la structure semi-conductrice recouverte de la couche cristalline de passivation préalablement au dépôt de couches supplémentaires de la structure semi-conductrice à base de nitrures d'éléments III.

Par ailleurs, le dépôt de la couche cristalline qui recouvre la totalité de la surface permet de s'affranchir des phases empiriques de mise au point et d'optimisation des procédés de l'art antérieur basés sur une étape de dépôt d'une couche nanoporeuse de SiNx, notamment la détermination de la taille optimum des nanopores ainsi que de la densité optimum des nanopores.

L'étape de dépôt d'une couche cristalline de passivation à base de silicium permet en outre une croissance ultérieure d'une couche cristalline sur celle-ci, par exemple une couche à base de nitrure d'éléments III, alors qu'une couche amorphe nanoporeuse recouvrant la couche à base de nitrure d'éléments III ne permettrait pas cette croissance ultérieure. L'image de diffraction décrite correspond à un arrangement périodique hexagonal tourné de 30° par rapport au réseau de la couche à base de nitrure d'éléments III et de paramètre de maille $\sqrt{3}$ fois plus grand que le paramètre de maille du réseau de la couche à base de nitrure d'éléments III, qui permet de favoriser cette croissance ultérieure d'une couche cristalline.

Il sera entendu dans la suite que lorsqu'une couche A est mentionnée comme étant sur une couche B, celle-ci peut être directement sur la couche B, ou peut être située au-dessus de la couche B et séparée de ladite couche B par une ou plusieurs couches intermédiaires.

Il sera également entendu que lorsqu'une couche A est mentionnée comme étant sur une couche B, celle-ci peut couvrir toute la surface de la couche B, ou une portion de ladite couche B.

Des aspects préférés mais non limitatif du dispositif selon l'invention sont les suivants :

- la couche cristalline de passivation est en relation épitaxiale avec la couche à base de nitrures d'éléments III;
- une image de diffraction de ladite couche cristalline de passivation obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci ;
- ladite couche cristalline de passivation est constituée d'atomes liés à la surface de la couche à base de nitrures d'éléments III et agencés selon un arrangement périodique hexagonal tourné de 30° par rapport au réseau de la couche de nitrure d'éléments III et avec un paramètre de maille $\sqrt{3}$ fois plus grand que le paramètre de maille du réseau de la couche à base de nitrure d'éléments III ;

- l'étape de dépôt de la couche cristalline de passivation consiste en un dépôt sous ultra-vide ;
- l'étape de dépôt de la couche cristalline de passivation consiste en un dépôt par épitaxie par jets moléculaires ;
- le procédé comprend une étape de mesure du taux de couverture de la couche cristalline de passivation par diffraction d'électrons en incidence rasante suivant la direction cristallographique [1-100] pendant l'étape de dépôt de la couche cristalline de passivation de sorte à obtenir une image de diffraction de ladite couche cristalline de passivation, dans lequel la durée de l'étape de dépôt de la couche cristalline de passivation est fonction de l'intensité d'au moins une raie de diffraction d'ordre non-entier de cette image de diffraction de la couche cristalline de passivation obtenue par diffraction électronique suivant la direction [1-100] ;
- l'étape de dépôt de la couche cristalline de passivation consiste en un dépôt en phase vapeur;
- l'étape de dépôt de la couche cristalline de passivation consiste en un dépôt par épitaxie en phase vapeur aux organométalliques ;
- la couche cristalline de passivation présente une épaisseur inférieure à 6 Å ;
- le procédé comprend une étape de formation sur un substrat d'une couche tampon, ladite couche tampon comprenant la couche à base de nitrures d'éléments III sur laquelle est déposée la couche cristalline de passivation ;
- la couche tampon a, à l'issue de sa formation, une épaisseur comprise entre 10 et 200 nm ;
- le substrat est à base de silicium et l'étape de formation de la couche tampon inclut le dépôt d'une couche de nitrure d'aluminium AlN ;
- l'étape de formation de la couche tampon inclut le dépôt d'une couche de nitrure de gallium et d'aluminium AlGaN sur la couche de nitrure d'aluminium.

L'invention concerne également une structure semi-conductrice passivée formant support pour une structure à base de nitrures d'éléments III, selon la revendication 15.

Des aspects préférés mais non limitatifs de la structure selon l'invention sont les suivants :

- la couche cristalline de passivation est en relation épitaxiale avec la couche à base de nitrures d'éléments III;
- une image de diffraction de ladite couche cristalline de passivation obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci ;

- ladite couche cristalline de passivation est constituée d'atomes liés à la surface de la couche à base de nitrures d'éléments III et agencés selon un arrangement périodique hexagonal tourné de 30° par rapport au réseau de la couche à base de nitrure d'éléments III et avec un paramètre de maille $\sqrt{3}$ fois plus grand que le paramètre de maille du réseau de la couche à base de nitrure d'éléments III;
- la couche cristalline de passivation présente une épaisseur inférieure à 6 Å ;
- la couche à base de nitrures d'éléments III est une couche auto-supportée ;
- la structure comprend un substrat et une couche tampon sur le substrat, la couche tampon constituant la couche à base de nitrures d'éléments III dont la totalité de la surface est continûment recouverte par une couche cristalline de passivation ;
- la couche tampon présente une épaisseur comprise entre 10 et 200 nm;
- le substrat est à base de silicium et la couche tampon comporte une couche de nitrure d'aluminium AlN et en outre une couche de nitrure de gallium et d'aluminium AlGaN sur la couche de nitrure d'aluminium AlN ;
- la structure comprend un substrat à base de saphir Al2O3, de silicium Si, de silicium sur isolant SOI, de carbure de silicium SiC, de nitrure d'aluminium AlN, d'oxyde de zinc ZnO ou d'arséniure de gallium GaAs.

## BREVE DESCRIPTION DES DESSINS

D'autres avantages et caractéristiques du procédé selon l'invention et du produit associé ressortiront mieux de la description qui va suivre de plusieurs variantes d'exécution, données à titre d'exemples non limitatifs, à partir des dessins annexés sur lesquels :

- la figure 1 illustre un exemple de procédé de fabrication d'une structure semi-conductrice à base de nitrures d'éléments III ;
- la figure 2 illustre schématiquement un exemple de produit obtenu en mettant en œuvre le procédé illustré à la figure 1,
- les figures 3 et 4 illustrent deux images de diffraction suivant les directions cristallographiques [1-100] et [1-210], respectivement, d'une couche cristalline de passivation selon l'invention,
- la figure 5 illustre un support ayant une structure mésa,
- la figure 6 illustre un support ayant une structure caisson, et
- la figure 7 illustre une courbe représentative de l'évolution temporelle de l'intensité des raies d'ordre non entier d'une image de diffraction lors du dépôt d'une couche cristalline.

Dans les différentes figures, les mêmes références désignent des éléments similaires.

## DESCRIPTION DETAILLEE DE L'INVENTION

L'invention concerne la passivation d'une structure semi-conductrice au moyen d'une couche cristalline de passivation recouvrant la totalité d'une surface d'une couche à base de nitrures d'éléments III de ladite structure. Cette couche cristalline de passivation est en relation épitaxiale avec couche à base de nitrures d'éléments III sur laquelle elle est déposée. Cette couche cristalline de passivation est déposée sur ladite surface à partir d'atomes de silicium et d'azote, et présente des atomes de silicium et d'azote liés à la surface de la couche à base de nitrure d'éléments III et agencés selon un arrangement périodique de sorte qu'une image de diffraction de ladite couche cristalline de passivation obtenue par diffraction d'électrons en incidence rasante suivant la direction [1-100] comporte :

- une raie centrale (0, 0) et des raies d'ordre entier (0, -1) et (0, 1),
- deux raies de diffraction d'ordre non-entier (0, -1/3) et (0, -2/3) entre la raie centrale (0, 0) et la raie d'ordre entier (0, -1), et
- deux raies de diffraction d'ordre non-entier (0, 1/3) et (0, 2/3) entre la raie centrale (0, 0) et la raie d'ordre entier (0, 1).

Une telle image de diffraction correspond à un arrangement périodique hexagonal tourné de 30° par rapport au réseau de la couche à base de nitrure d'éléments III et avec un paramètre de maille $\sqrt{3}$ fois plus grand que le paramètre de maille de la couche à base de nitrure d'éléments III.

La couche à base de nitrures d'éléments III peut être une couche épaisse (« template » en anglais) ou auto-supportée dit substrat massif (« bulk substrate » en anglais), auquel cas elle constitue la structure semi-conductrice. La structure semi-conductrice à base de nitrure d'éléments III peut ainsi être une couche épaisse GaN, AlN etc ..., ou un substrat massif GaN, AlN etc ..., ou bien encore un structure épitaxée ("epiwafer" en anglais).

Elle peut également être supportée par un substrat et une couche tampon. La description qui suit sera faite en référence à cette configuration. Elle peut ainsi par exemple présenter une configuration de diode électroluminescente, de transistor à grande mobilité d'électrons (HEMT de l'anglais « high electron mobility transistor »).

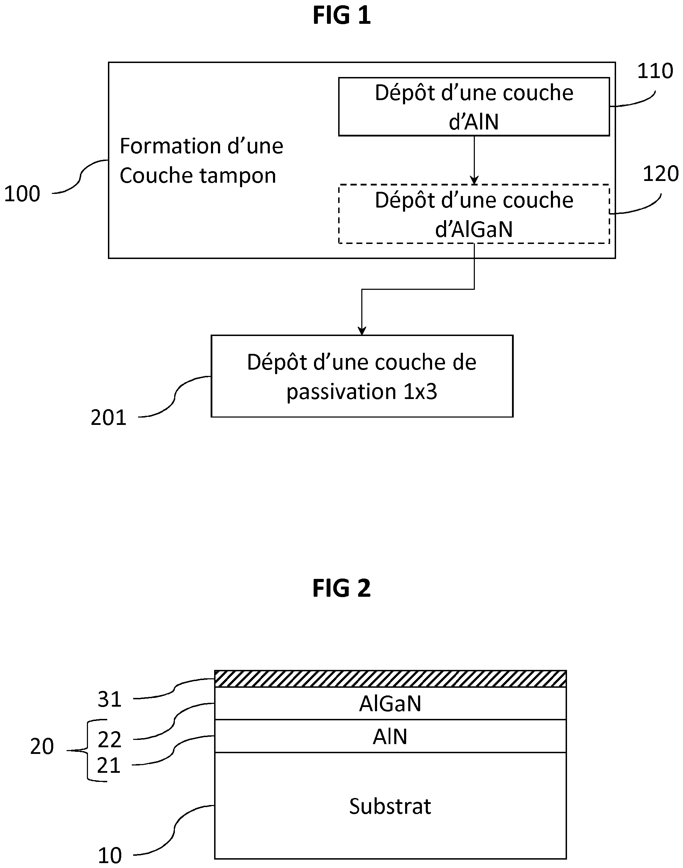

On a illustré à la figure 1 une variante de réalisation du procédé selon l'invention. Le procédé comprend les étapes consistant à :

- former 100 une couche tampon sur un substrat, ladite couche comprenant une couche à base de nitrures d'éléments
- déposer 201 une couche cristalline de passivation sur la couche tampon.

### Substrat

Pour fabriquer la structure semi-conductrice, on utilise un substrat 10 sur lequel différentes étape de dépôt sont mises en œuvre.

Le substrat 10 utilisé peut être du saphir Al203, du silicium Si, du carbure de silicium SiC, du nitrure d'aluminium AlN, ou de l'oxyde de zinc ZnO ou de l'arséniure de gallium GaAs. Dans un mode de réalisation, le substrat est du silicium.

L'utilisation d'un substrat de silicium présente de nombreux avantages par rapport à l'utilisation d'un substrat de saphir ; notamment :

- un substrat de silicium est moins onéreux qu'un substrat de saphir ;
- les dimensions des substrats de silicium (généralement jusqu'à 12 pouces, soit 30,48 cm) sont plus importantes que celles des substrats de saphir (généralement jusqu'à 6 pouces, soit 15,24 cm) ; il est donc possible de fabriquer une couche de nitrure de gallium GaN de plus grande surface en utilisant un substrat de silicium ;
- les différentes étapes de fabrication des composants post-croissance (polissage face arrière, report face avant, retrait du substrat, etc.) après la croissance de la couche de nitrure de gallium GaN sont plus simples et moins couteuses dans le cas de l'utilisation d'un substrat de silicium que dans le cas d'un substrat de saphir.

Ainsi, l'utilisation de substrats de silicium permet par exemple la fabrication de diodes électroluminescentes (LED) à bas coût de production, ce qui peut être particulièrement avantageux dans le domaine de l'éclairage.

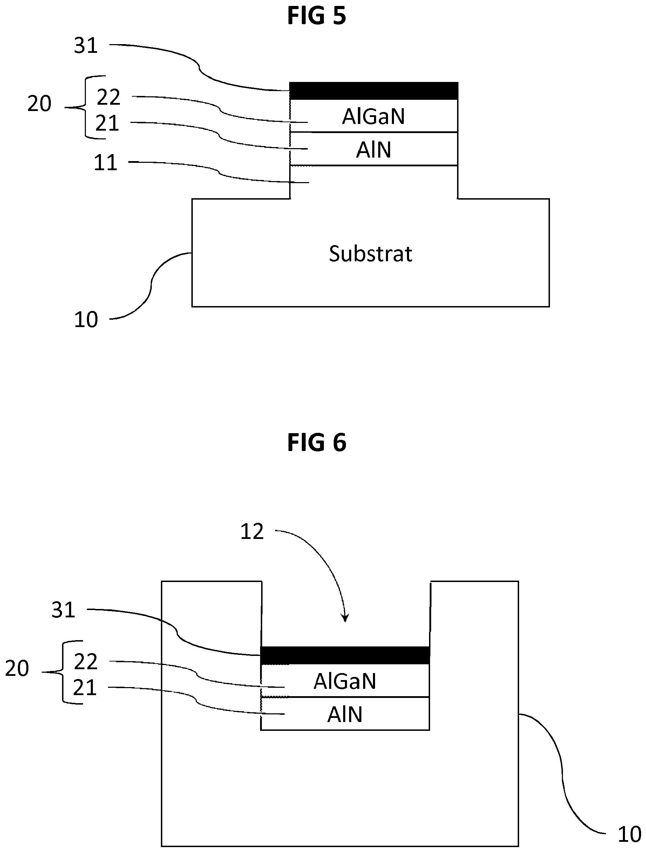

Avantageusement, le substrat 10 peut être un substrat à motif comprenant une structure mésa 11 ayant la forme d'un plateau surélevé (dont la taille peut varier de 10x10 $\mu$m à 400x400 $\mu$m) et obtenu par gravure de la surface du substrat entourant le plateau, comme illustré sur la figure 5, ou bien encore une structure caisson, comme représenté sur la figure 6, dans laquelle la couche tampon 20 à base de nitrure d'éléments III, en l'espèce en AlN et en AlGaN, et la couche de passivation la recouvrant totalement sont situées dans un renfoncement 12 ménagé dans le substrat 10. Un autre procédé de fabrication des motifs, comme par exemple le masquage partiel de la surface par un masque en matériaux diélectriques, peut être avantageusement utilisé.

L'utilisation d'un tel substrat à motif permet de limiter la fissuration de la couche de nitrure de gallium épitaxiée sur le substrat 10, et ainsi d'augmenter l'épaisseur critique de nitrure de gallium GaN que l'on peut déposer sur le substrat 10 sans créer de fissures.

Par exemple, il est possible de réaliser une couche non fissurée de nitrure de gallium GaN d'épaisseur 5μm en utilisant un substrat incluant une structure mésa de 200x200μm alors que l'utilisation d'un substrat non structuré ne permet de réaliser qu'une couche non fissurée de nitrure de gallium GaN d'épaisseur 1 μm.

*Formation de la couche tampon*

Le procédé comprend une étape de formation 100 d'une couche tampon 20, dont la couche supérieure constitue alors la couche à base de nitrures d'éléments III sur laquelle sera déposée la couche cristalline de passivation 31. Cette couche tampon peut comprendre une couche de nitrure d'aluminium AlN, de nitrure d'aluminium-gallium AlGaN, de nitrure d'aluminium-gallium-bore l'AlGaBN, un empilement AlN/AlGaN, un graduel AlGaN, de l'oxyde de zinc ZnO, du nitrure de bore BN ou encore de carbure de silicium SiC. Cependant, dans tous les cas, la couche tampon présente une couche supérieure à base de nitrures d'éléments III, tel que le nitrure d'aluminium AlN, le nitrure d'aluminium-gallium AlGaN.

Dans le cas du présent exemple, cette étape de formation 100 comprend le dépôt 110 d'une couche 21 de nitrure d'aluminium AlN. La formation d'une couche tampon 20 incluant une couche 21 de nitrure d'aluminium AlN permet d'améliorer la qualité de la couche de nitrure de gallium GaN déposée ultérieurement.

Par exemple, lorsque le substrat 10 utilisé est du silicium Si, la croissance directe de nitrure de gallium GaN sur le silicium Si est très difficile du fait notamment de la haute réactivité chimique entre le gallium Ga et le silicium Si à haute température.

La formation d'une couche tampon 20 incluant une couche 21 de nitrure d'aluminium AlN permet de remédier à ces difficultés, et donc d'améliorer la qualité de la couche de nitrure de gallium GaN épitaxiée ultérieurement.

La couche tampon 20 peut présenter une épaisseur comprise entre 10 nm et 500 nm, préférentiellement entre 50 nm et 200 nm. Une couche tampon avec une épaisseur supérieure à 200 nm permet d'obtenir une bonne qualité cristalline de la couche tampon 20, et donc d'améliorer celle de la couche de nitrure d'éléments III épitaxiée ultérieurement.

La couche cristalline de passivation selon l'invention, qui recouvre totalement la couche tampon, permet cependant d'assurer une bonne qualité cristalline de la couche de nitrure d'éléments III épitaxiée ultérieurement même si la qualité cristalline de la couche tampon n'est pas maximale. Par conséquent, il n'est pas nécessaire que la couche tampon 20 atteigne une épaisseur supérieure à 200 nm. Ainsi, de préférence, la couche tampon 20 présente une épaisseur comprise entre 10 et 200 nm, voire entre 50 et 100 nm.

Le fait de limiter l'épaisseur de la couche tampon 20 en deçà de 200 nm permet avantageusement de réduire la durée du procédé, le temps de croissance d'une couche 21 de nitrure d'aluminium AlN étant relativement long. Un autre avantage est le fait qu'avec une couche tampon 20 peu épaisse, qui se trouve recouverte en totalité par une couche cristalline de passivation, le problème des dislocations dans cette couche tampon résolu par la couche cristalline de passivation s'en trouve d'autant plus rapidement résolu, ce qui empêche les dislocations de se propager et de provoquer des dislocations.

L'étape de formation 100 de la couche tampon 20 peut également comprendre une étape optionnelle de dépôt 120 d'une couche 22 de nitrure d'aluminium et de gallium AlGaN sur la couche 21 de nitrure d'aluminium AlN. Ceci permet d'obtenir une couche tampon complexe 20 de nitrure d'aluminium AlN et de nitrure d'aluminium et de gallium AlGaN. La couche 22 de nitrure d'aluminium et de gallium AlGaN permet de réduire la densité de dislocation de la couche sur laquelle la couche cristalline de passivation est déposée.

Avantageusement, l'épaisseur de la couche tampon 20, et donc la somme des épaisseurs des couches 21, 22 de nitrure d'aluminium AlN et de nitrure d'aluminium et de gallium AlGaN peut être comprise entre 10 nm et 500 nm, et de préférence entre 50 et 200 nm, avec par exemple la répartition suivante :

- 25-100 nm de nitrure d'aluminium AlN,
- 25-400 nm de nitrure d'aluminium et de gallium AlGaN.

Ceci permet de réduire la durée de croissance de la couche tampon tout en bénéficiant des avantages relatifs au dépôt de couches de nitrure d'aluminium et de nitrure d'aluminium et de gallium.

De préférence, la surface de la couche tampon, c'est-à-dire la surface de la couche à base de nitrures d'éléments III, sur laquelle va être déposée la couche cristalline de passivation, est formée aussi lisse que possible.

A cet effet, il est avantageux de réaliser le traitement de surface de la couche tampon 20 à une température inférieure à 950°C sous un flux d'atomes de silicium et un flux d'atomes d'azote, par exemple des molécules d'ammoniac NH3, dans un réacteur d'épitaxie par jets moléculaires. Ce faisant, la surface ne se dégrade pas et reste lisse.

*Dépôt d'une couche cristalline de passivation*

Le procédé comprend une étape de dépôt 201 d'une couche cristalline de passivation 31 sur la couche tampon 20. La couche cristalline de passivation 31 est en relation épitaxiale avec la couche tampon 20.

Ce dépôt d'une couche cristalline de passivation 31 est par exemple obtenu en exposant la surface de la couche tampon 20 à un précurseur contenant des atomes de silicium Si. Le précurseur contenant des atomes de silicium peut par exemple être le silane $SiH_4$, le disilane $Si_2H_6$, ou le timethylsilane $SiH(CH_3)_3$. Le dépôt peut également être réalisé en combinant les atomes de silicium à un flux d'atomes d'azote obtenu à partir par exemple de molécules d'ammoniac NH3.

L'étape de dépôt de la couche cristalline de passivation 31 correspond à un traitement de surface qui conduit à une reconstruction de surface des atomes déposés à la surface de la couche tampon 20.

En effet, suite à l'exposition de la surface de la couche tampon 20 aux atomes de silicium Si et aux atomes d'azote, les atomes se lient à la surface de la couche tampon en créant un arrangement périodique hexagonal tourné de 30° par rapport au réseau de la couche à base de nitrure d'éléments III sur laquelle les atomes sont déposés et avec un paramètre de maille $\sqrt{3}$ fois plus grand que celui de la couche à base de nitrure d'éléments III.

La formation de cette reconstruction de surface est mesurable par des techniques de diffraction électronique et on peut quantifier son taux de couverture de la surface en enregistrant l'intensité des raies de diffraction spécifiques de cette reconstruction de surface. La diffraction des électrons est une technique utilisée pour l'étude de la matière qui consiste à bombarder d'électrons un échantillon et à observer la figure de diffraction résultante.

Un exemple de technique de diffraction électronique utilisable dans le cadre de la présente invention pour étudier la formation de la couche cristalline durant la phase de dépôt est la diffraction d'électrons de haute énergie en réflexion ("reflection high energy electron diffraction" en anglais ou RHEED), qui est une technique permettant de déterminer la structure cristalline de la surface dans un environnement ultra-vide.

La technique RHEED permet notamment de déterminer la reconstruction de la surface, de mesurer la vitesse de croissance et d'apprécier qualitativement la planéité de la surface. Un dispositif RHEED consiste en un canon à électrons qui permet de créer un faisceau d'électrons monocinétique d'une énergie de 10 à 50 keV focalisé sur la surface. La longueur d'onde associée aux électrons est de l'ordre de 0.1 Å. Le faisceau atteint la surface en incidence rasante avec un angle de 1 à 2 degrés. Dans cette configuration l'interaction des électrons avec la surface se limite à quelques plans atomiques. Les électrons réfléchis et diffractés par les atomes de la surface sont collectés sur un écran fluorescent qui permet de visualiser le cliché de diffraction correspondant et ce cliché peut ensuite être numérisé à l'aide d'une caméra CCD. Le document "Reflection High Energy Electron Diffraction", par Ayahiko Ichimiya et Philip I. Cohen, Cambridge University Press, 2004, décrit cette technique.

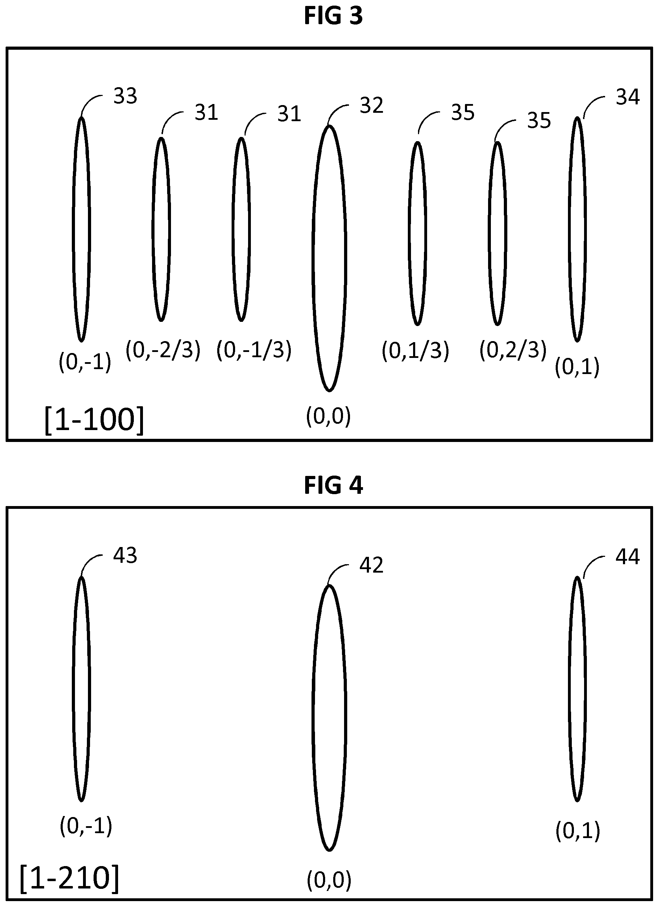

En référence aux figures 3 et 4, on a illustré deux images de diffraction de la couche cristalline suivant les directions cristallographiques respectives [1-100] et [1-210].

Dans la figure 4, l'image de diffraction de la couche cristalline selon la direction [1-210] comprend uniquement des raies de diffraction d'ordre entier: une raie centrale (0,0) 42 et deux raies d'ordre entier (0, -1) 43 et (0, 1) 44 de part et d'autre de ladite raie centrale 42. Ainsi il n'y a pas de raies d'ordre non-entier entre les raies d'ordre entiers (0,-1) et (0, 1) et la raie centrale (0, 0). Il est à noter que l'écartement entre des raies de diffraction d'ordre entier est inversement proportionnel au paramètre de maille dans le plan de la surface.

Dans la figure 3 en revanche, correspondant à l'image de diffraction de la couche cristalline selon la direction [1-100], la présence d'une reconstruction de surface conduit à la présence de raies supplémentaires d'ordre fractionnaire, c'est-à-dire d'ordre non-entier, en l'occurrence d'ordre 1/3 caractéristique d'une reconstruction dite 1x3. L'image de diffraction de la couche cristalline selon la direction [1-100] comprend ainsi :

- une raie centrale (0, 0) et des raies d'ordre entier (0, -1) et (0, 1),
- deux raies de diffraction d'ordre non-entier 31, dites (0,-1/3) et (0, -2/3), entre les raies (0, 0) 32 et (0, -1) 33, et
- deux raies de diffraction d'ordre non-entier 35, dites (0, 1/3) et (0, 2/3), entre les raies (0, 0) 32 et (0, 1) 34.

Par conséquent, l'image de diffraction suivant la direction [1-210] ne présentant qu'un espace entre les raies d'ordre entier, alors que l'image de diffraction suivant la direction [1-100] présentant trois espaces entre les raies d'ordre entier, c'est pourquoi cette couche cristalline est dénommée 1x3.

Ainsi, et contrairement aux procédés de l'art antérieur comprenant une étape de dépôt d'une couche nanoporeuse de SiNx dont la structure et la composition exacte sont inconnues, le procédé selon l'invention propose le dépôt d'une couche cristalline de passivation dite 1x3 de structure et de composition parfaitement définie, et dont la densité de pores est de préférence la plus faible possible, voire sensiblement nulle.

De fait, dans les procédés de l'état de la technique, on cherche à éviter un taux de couverture total de la surface de la couche à base de nitrure d'éléments III. Or, les inventeurs ont découvert que la densité de dislocations est minimale lorsque la couche cristalline recouvre la totalité de la surface de la couche à base de nitrure d'éléments III.

Le dépôt de la couche cristalline de passivation 1x3 induit une passivation de la surface de la couche tampon 20. Cette passivation permet de rendre la couche tampon 20 inerte vis-à-vis d'une exposition à l'air et ainsi d'empêcher toute réaction d'oxydation. D'ailleurs, une exposition à l'air d'une structure semi-conductrice présentant une telle couche cristalline de passivation 1x3 sur sa couche supérieure à base de nitrure d'éléments III n'altère pas la reconstruction de surface 1x3 de ladite couche cristalline de passivation 1x3.

Afin que la passivation par la couche cristalline de passivation 31 permette une bonne protection de la couche à base de nitrure d'éléments III à la surface de laquelle elle est déposée, la couche cristalline de passivation 31 recouvre la totalité de la surface de cette couche à base de nitrure d'éléments III de façon continue, c'est-à-dire en l'absence des trous ou d'ouvertures contrairement à ce qui est recherché par l'homme de l'art lors de la fabrication d'une couche de SiNx micro-nano-poreuse.

A cet égard, il est à noter que la couche cristalline de passivation 31 présente une épaisseur très faible, de l'ordre de la monocouche d'atomes de silicium, soit de l'ordre de 2 Å à 3 Å. De fait, afin de conserver le caractère cristallin de la couche de passivation, l'épaisseur de celle-ci est de préférence inférieure à 6 Å.

*Obtention d'un support pour la croissance de nitrures d'éléments III*

A l'issue de l'étape de dépôt 201 de la couche cristalline de passivation 31, on obtient un support pour la croissance d'une structure semi-conductrice à base de nitrures d'éléments III, telle qu'une couche de nitrure de gallium GaN.

*Techniques de croissance utilisées*

L'étape de dépôt de la couche cristalline de passivation 31 peut consister en un dépôt sous ultra-vide.

Avantageusement, les étapes de :

- formation de la couche tampon 20, et/ou de
- dépôt de la couche cristalline de passivation 31 sur la couche tampon 20, peuvent être réalisées par épitaxie par jets moléculaires EJM (ou « MBE » sigle de l'expression anglo-saxonne « molecular beam epitaxy »), qui se réalise dans un environnement ultra-vide.

Il est également possible que l'étape de dépôt de la couche cristalline de passivation 31 consiste en un dépôt en phase vapeur, plus précisément en un dépôt par épitaxie en phase vapeur aux organométalliques EPVOM (ou « MOVPE » sigle de l'expression anglo-saxonne « Metalorganic vapour phase epitaxy »).

Le fait de former la couche tampon par épitaxie par jets moléculaires - et donc dans un environnement ultravide - présentent de nombreux avantages par rapport aux techniques de formation de la couche tampon par épitaxie en phase vapeur aux organométalliques.

Notamment, la formation de la couche tampon 20 par épitaxie par jets moléculaires permet :

- d'une part d'éliminer toute trace de gaz réactif dans l'environnement du substrat ,et donc de limiter les risques de réaction parasite de nitruration de la surface du substrat,
- d'autre part de limiter l'encrassement du réacteur de croissance et donc d'améliorer le rendement de fabrication en diminuant la fréquence des opérations de maintenance du réacteur.

En outre, la formation de la couche tampon 20 par épitaxie par jets moléculaires permet d'obtenir une surface de la couche à base de nitrures d'éléments III qui est très lisse, améliorant ainsi la formation de la couche cristalline de passivation 31.

Par ailleurs, l'utilisation d'ultravide en EJM permet également de faire un suivi in-situ - par exemple par diffraction électronique - du dépôt de la couche cristalline. Ceci permet un suivi précis de l'étape de dépôt de la couche cristalline de sorte à stopper cette étape lorsque la couche cristalline recouvre totalement la surface.

Ainsi, le procédé peut comprendre une étape de mesure du taux de couverture de la couche cristalline de passivation 31 par diffraction d'électrons en incidence rasante suivant la direction [1-100] pendant l'étape de dépôt de la couche cristalline de passivation 31 de sorte à obtenir une image de diffraction de ladite couche cristalline de passivation, dans lequel la durée de l'étape de dépôt de la couche cristalline de passivation est liée à l'intensité d'au moins une raie de diffraction d'une image de diffraction de la couche cristalline de passivation obtenue par diffraction électronique suivant la direction cristallographique [1-100].

Comme indiqué précédemment, l'image de diffraction de la couche cristalline de passivation 31 suivant la direction [1-100] comporte alors :

- une raie centrale (0, 0) et des raies d'ordre entier (0, -1) et (0, 1),
- deux raies de diffraction d'ordre non-entier (0, -1/3) et (0, -2/3) entre la raie centrale (0, 0) et la raie d'ordre entier (0, -1), et
- deux raies de diffraction d'ordre non-entier (0, 1/3) et (0, 2/3) entre la raie centrale (0, 0) et la raie d'ordre entier (0, 1).

L'étape de dépôt de la couche cristalline de passivation 31 est interrompue lorsque l'intensité lumineuse des raies intermédiaires d'ordre non-entier de l'image de diffraction (suivant la direction cristallographique [1-100]) est maximale, ce qui correspond à un taux de couverture complet de la surface de la couche à base de nitrure d'éléments III par la couche cristalline de passivation 31.

Ce maximum d'intensité est facilement identifiable. En effet, en utilisant une caméra CCD, il suffit d'enregistrer le profil d'intensité d'une des raies de diffraction d'ordre non-entier suivant la direction [1-100] en fonction du temps de dépôt de la couche de passivation. Dans un premier temps, la raie de diffraction d'ordre non-entier apparait puis son intensité s'accroît au cours du dépôt, pour arriver à un pallier avant dans un deuxième temps de décroître et finir pas disparaître. Le maximum d'intensité est donc détectable par la stabilité de cette intensité, qui peut durer plusieurs minutes.

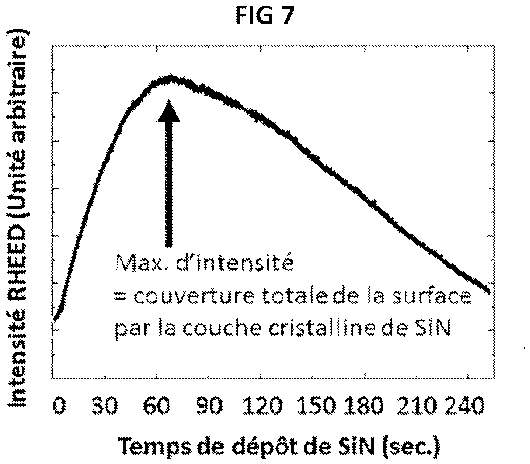

La figure 7 montre ainsi un exemple de courbe représentative de l'évolution temporelle de l'intensité d'une raie d'ordre non-entier dans une image de diffraction lors du dépôt d'une couche cristalline. On constate que cette intensité commence tout d'abord par croître entre 0 et 60 secondes, puis décroît après 90 secondes. On se situe donc entre 60 secondes et 90 secondes au niveau d'un maximum d'intensité.

Dans les conditions de dépôt de la figure 7, on peut donc interrompre l'étape de dépôt de la couche cristalline de passivation à un instant correspondant à un maximum d'intensité lumineuse des raies intermédiaires d'ordre non-entier d'une image de diffraction suivant la direction cristallographique [1-100] en interrompant le dépôt entre 60 et 90 secondes après son début.

Une structure semi-conductrice ainsi passivée peut dès lors être exposée à l'air, entreposée ou manipulée sans dégradation de sa surface et en conservant ses propriétés spécifiques conduisant à un mode de croissance tridimensionnel. Une croissance ultérieure d'une couche de nitrure d'éléments III peut être reprise aisément sur une telle couche de passivation. On qualifie une telle structure du terme anglais « epi-ready » pour signifier qu'une épitaxie peut être entreprise sur ladite structure sans avoir à préparer chimiquement la surface au préalable.

*Exemple de procédé de fabrication*

On va maintenant décrire un exemple de procédé selon l'invention.

Le substrat de silicium utilisé présente une orientation cristallographique (111).

On forme, sur le substrat de silicium, une couche tampon de nitrure d'aluminium AlN par épitaxie par jets moléculaires. La formation de la couche tampon est interrompue lorsque l'épaisseur de celle-ci est comprise entre 10 et 200 nm.

On réalise ensuite l'étape de dépôt de la couche cristalline 1x3. Un traitement de la surface de la couche tampon par épitaxie par jets moléculaires est mis en œuvre en utilisant des atomes de silicium et des molécules d'ammoniac NH3. Ce traitement de surface conduit à la formation d'une nouvelle structure cristalline épitaxiale bien définie, mesurable et identifiable par diffraction électronique.

Durant le dépôt de la couche cristalline, la surface est observée par une technique de diffraction des électrons consistant à envoyer en incidence rasante un faisceau d'électrons monocinétiques sur la couche cristalline en cours de formation afin d'observer la figure de diffraction résultante (suivant la direction cristallographique [1-100]).

La structure périodique ordonnée de la couche cristalline 1x3 permet de diffracter les électrons et ainsi d'obtenir une image de diffraction spécifique.

La durée de l'étape de dépôt de la couche cristalline est fonction de l'intensité des raies de diffraction d'ordre non-entier observées sur l'image de diffraction.

En particulier, l'étape de dépôt de la couche cristalline est interrompue lorsque l'intensité d'au moins l'une des raies de diffraction observées sur la figure de diffraction est maximale, ce qui est détectable par la stabilité de cette intensité.

On obtient alors une structure semi-conductrice à base de nitrure d'élément III comprenant une couche tampon à base de nitrure d'élément III dont la totalité de la surface est totalement recouverte par une couche cristalline de passivation comprenant des atomes de silicium et d'azote liés à la surface et agencés selon un arrangement périodique de sorte que l'image de diffraction de la couche cristalline suivant la direction [1-100] comporte :

- une raie centrale (0, 0) et des raies d'ordre entier (0, -1) et (0, 1),
- deux raies de diffraction d'ordre non entier (0, -1/3) et (0, -2/3) entre la raie centrale (0, 0) et la raie d'ordre entier (0, -1), et
- deux raies de diffraction d'ordre non entier (0, 1/3) et (0, 2/3) entre la raie centrale (0, 0) et la raie d'ordre entier (0, 1).

Cela correspond à un arrangement périodique hexagonal tourné de 30° par rapport au réseau de la couche à base de nitrure d'éléments III et avec un paramètre de maille $\sqrt{3}$ fois plus grand que le paramètre de maille de ladite couche à base de nitrure d'éléments III.

L'homme du métier aura compris que de nombreuses modifications peuvent être apportées au procédé décrit ci-dessus sans sortir matériellement des nouveaux enseignements présentés ici.

Par exemple, les étapes consistant à former la couche tampon et à déposer la couche cristalline peuvent être réalisées par EPVOM. Par ailleurs, l'étape de croissance de la structure semi-conductrice à base de nitrures d'éléments III peut être réalisée par EJM.

Il est donc bien évident que les exemples qui viennent d'être donnés ne sont que des illustrations particulières en aucun cas limitatives.

**Revendications**

1. Procédé de fabrication d'une structure semi-conductrice passivée formant support pour une structure à base de nitrures d'éléments III le procédé comprenant une étape de dépôt (201) d'une couche cristalline de passivation (31) recouvrant la totalité de la surface d'une couche à base de nitrures d'éléments III de la structure semi-conductrice, ladite couche cristalline de passivation étant déposée à partir d'un précurseur contenant des atomes de silicium et ladite couche cristalline de passivation (31) étant constituée d'atomes de silicium liés à la surface de la couche à base de nitrures d'éléments III, le temps de dépôt de ladite couche cristalline de passivation étant choisi de manière à obtenir une couche cristalline présentant une périodicité triple d'atomes de silicium suivant la direction cristallographique [1-100] de sorte qu'une image de diffraction de ladite couche cristalline de passivation obtenue par diffraction d'électrons en incidence rasante suivant la direction [1-100] comporte :

- une raie centrale (0, 0) et des raies d'ordre entier (0, -1) et (0, 1),
- deux raies de diffraction d'ordre non-entier (0, -1/3) et (0, -2/3) entre la raie centrale (0, 0) et la raie d'ordre entier (0, -1), et
- deux raies de diffraction d'ordre non-entier (0, 1/3) et (0, 2/3) entre la raie centrale (0, 0) et la raie d'ordre entier (0, 1) ; le procédé étant **caractérisé en ce que** l'intensité lumineuse desdites raies intermédiaires d'ordre non entier de l'image de diffraction en fonction dudit temps de dépôt de ladite couche cristalline de passivation est maximale au moment de l'interruption du dépôt.

2. Procédé selon la revendication précédente, dans lequel la couche cristalline de passivation présente une périodicité simple suivant la direction cristallographique [1-210] de sorte qu'une image de diffraction de ladite couche cristalline de passivation obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci.

3. Procédé selon l'une des revendications précédentes, dans lequel ladite couche cristalline de passivation est constituée d'atomes de silicium liés à la surface de la couche à base de nitrures d'éléments III et agencés selon un arrangement périodique hexagonal tourné de 30° par rapport au réseau de la couche de nitrure d'éléments III et avec un paramètre de maille $\sqrt{3}$ fois plus grand que le paramètre de maille du réseau de la couche à base de nitrure d'éléments III.

4. Procédé selon l'une des revendications précédentes, dans lequel l'étape de dépôt de la couche cristalline de passivation consiste en un dépôt sous ultra-vide.

5. Procédé selon la revendication précédente, dans lequel l'étape de dépôt de la couche cristalline de passivation consiste en un dépôt par épitaxie par jets moléculaires.

6. Procédé selon la revendication précédente, comprenant une étape de mesure du taux de couverture de la couche cristalline de passivation par diffraction d'électrons en incidence rasante suivant la direction [1-100] pendant l'étape de dépôt de la couche cristalline de passivation de sorte à obtenir une image de diffraction de ladite couche cristalline de passivation, dans lequel la durée de l'étape de dépôt de la couche cristalline de passivation est fonction de l'intensité d'au moins une raie de diffraction d'ordre non-entier d'une image de diffraction de la couche cristalline de passivation obtenue par diffraction électronique suivant la direction cristallographique [1-100].

7. Procédé selon la revendication précédente, dans lequel l'image de diffraction de la couche cristalline suivant la direction [1-100] comporte :

- une raie centrale (0, 0) et des raies d'ordre entier (0, -1) et (0, 1),
- deux raies de diffraction d'ordre non-entier (0, -1/3) et (0, -2/3) entre la raie centrale (0, 0) et la raie d'ordre entier (0, -1), et
- deux raies de diffraction d'ordre non-entier (0, 1/3) et (0, 2/3) entre la raie centrale (0, 0) et la raie d'ordre entier (0, 1).

l'étape de dépôt de la couche cristalline de passivation étant interrompue lorsque l'intensité lumineuse desdites raies d'ordre non-entier est maximale.

8. Procédé selon l'une des revendications 1 à 3, dans lequel l'étape de dépôt de la couche cristalline de passivation consiste en un dépôt en phase vapeur.

9. Procédé selon la revendication précédente, dans lequel l'étape de dépôt de la couche cristalline de passivation consiste en un dépôt par épitaxie en phase vapeur aux organométalliques.

10. Procédé selon l'une quelconque des revendications précédentes, dans lequel la couche cristalline de passivation présente une épaisseur inférieure à 6 Å.

11. Procédé selon l'une quelconque des revendications précédentes, comprenant une étape de formation (100) sur un substrat (10) d'une couche tampon (20), ladite couche tampon (20) comprenant la couche à base de nitrures d'éléments III sur laquelle est déposée la couche cristalline de passivation (31).

12. Procédé selon la revendication précédente, dans lequel la couche tampon (20) a, à l'issue de sa formation, une épaisseur comprise entre 10 et 200 nm.

**13.** Procédé selon l'une des revendications 11 à 12, dans lequel le substrat est à base de silicium et l'étape de formation (100) de la couche tampon (20) inclut le dépôt (110) d'une couche de nitrure d'aluminium AlN (21).

**14.** Procédé selon la revendication précédente, dans lequel l'étape de formation (100) de la couche tampon (20) inclut le dépôt (120) d'une couche de nitrure de gallium et d'aluminium AlGaN (22) sur la couche de nitrure d'aluminium.

**15.** Structure semi-conductrice passivée formant support pour une structure à base de nitrures d'éléments III, la structure semi-conductrice comprenant une couche à base de nitrures d'éléments III dont la totalité d'une surface est totalement recouverte par une couche cristalline de passivation (31), la couche cristalline de passivation pouvant être obtenue par une étape de dépôt, la couche cristalline de passivation étant constituée d'atomes de silicium liés à la surface et présentant une périodicité triple d'atomes de silicium suivant la direction cristallographique [1-100] de sorte qu'une image de diffraction de ladite couche cristalline de passivation obtenue par diffraction d'électrons en incidence rasante suivant la direction [1-100] comporte :

    - une raie centrale (0, 0) et des raies d'ordre entier (0, -1) et (0, 1),
    - deux raies de diffraction d'ordre non-entier (0, -1/3) et (0, -2/3) entre la raie centrale (0, 0) et la raie d'ordre entier (0, -1), et
    - deux raies de diffraction d'ordre non-entier (0, 1/3) et (0, 2/3) entre la raie centrale (0, 0) et la raie d'ordre entier (0, 1) ; la structure semi-conductrice étant **caractérisée en ce que** l'intensité lumineuse desdites raies intermédiaires d'ordre non entier de l'image de diffraction en fonction du temps de dépôt est maximale au moment de l'interruption du dépôt.

**16.** Structure selon la revendication précédente, dans laquelle la couche cristalline présente une périodicité simple suivant la direction cristallographique [1-210] de sorte qu'une image de diffraction de ladite couche cristalline de passivation obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci.

**17.** Structure selon l'une des revendications 15 ou 16, dans laquelle ladite couche cristalline de passivation est constituée d'atomes de silicium liés à la surface de la couche à base de nitrures d'éléments III et agencés selon un arrangement périodique hexagonal tourné de 30° par rapport au réseau de la couche à base de nitrure d'éléments III et avec un paramètre de maille $\sqrt{3}$ fois plus grand que le paramètre de maille du réseau de la couche à base de nitrure d'éléments III.

**18.** Structure selon l'une des revendications 15 à 17, dans lequel la couche cristalline de passivation présente une épaisseur inférieure à 0.6 nm.

**19.** Structure selon l'une des revendications 15 à 18, dans laquelle la couche à base de nitrures d'éléments III est une couche auto-supportée.

**20.** Structure selon l'une des revendications 15 à 18, comprenant un substrat (10) et une couche tampon (20) sur le substrat, la couche tampon constituant la couche à base de nitrures d'éléments III dont la totalité de la surface est continument recouverte par une couche cristalline de passivation (31).

**21.** Structure selon la revendication précédente, dans laquelle la couche tampon (20) présente une épaisseur comprise entre 10 et 200 nm.

**22.** Structure selon l'une des revendications 20 à 21, dans laquelle le substrat (10) est à base de silicium et la couche tampon comporte une couche de nitrure d'aluminium AlN (21) et en outre une couche de nitrure de gallium et d'aluminium AlGaN (22) sur la couche de nitrure d'aluminium AlN (21).

**23.** Structure selon l'une des revendications 20 et 21, dans laquelle le substrat est à base de saphir, de silicium Si, de silicium sur isolant SOI, de carbure de silicium SiC, de nitrure d'aluminium AlN, d'oxyde de zinc ZnO ou d'arséniure de gallium GaAs.

**Patentansprüche**

**1.** Verfahren zur Herstellung einer passivierten Halbleiterstruktur, die einen Träger für eine Struktur aus Nitriden von Elementen der Gruppe III bildet, wobei das Verfahren einen Schritt des Abscheidens (201) einer kristallinen Passivierungsschicht (31) umfasst, die die gesamte Oberfläche einer Schicht aus Nitriden von Elementen der Gruppe III der Halbleiterstruktur bedeckt, wobei die kristalline Passivierungsschicht aus einem Siliciumatome enthaltenden Vorläufer abgeschieden ist und die kristalline Passivierungsschicht (31) aus Siliciumatomen besteht, die an die Oberfläche der Schicht aus Nitriden von Elementen der Gruppe III gebunden sind, wobei die Abscheidungszeit der kristallinen Passivierungsschicht so gewählt wird, dass eine kristalline Schicht mit einer dreifachen Periodizität von Siliciumatomen in der kristallographischen Richtung [1-100] erhalten wird, so dass ein Beugungsbild der kristallinen Passivierungsschicht, das durch Elektronenbeugung mit streifendem Einfall in der Richtung [1-100] erhalten wird, Folgendes umfasst:

- einen zentralen Streifen (0, 0) und Streifen ganzzahliger Ordnung (0, -1) und (0, 1),
- zwei Beugungsstreifen nicht-ganzzahliger Ordnung (0, -1/3) und (0, -2/3) zwischen dem zentralen Streifen (0, 0) und dem Streifen ganzzahliger Ordnung (0, -1), und
- zwei Beugungsstreifen nicht-ganzzahliger Ordnung (0, 1/3) und (0, 2/3) zwischen dem zentralen Streifen (0, 0) und dem Streifen ganzzahliger Ordnung (0, 1);

wobei das Verfahren **dadurch gekennzeichnet ist, dass** die Lichtintensität der Zwischenstreifen nicht-ganzzahliger Ordnung des Beugungsbildes in Abhängigkeit von der Abscheidungszeit der kristallinen Passivierungsschicht zum Zeitpunkt der Unterbrechung der Abscheidung maximal ist.

2. Verfahren nach dem vorherigen Anspruch, wobei die kristalline Passivierungsschicht eine einfache Periodizität in der kristallographischen Richtung [1-210] aufweist, so dass ein Beugungsbild der kristallinen Passivierungsschicht, das durch Elektronenbeugung unter streifendem Einfall in der Richtung [1-210] erhalten wird, ein zentraler Streifen (0, 0) und Streifen ganzzahliger Ordnung (0, -1) und (0, 1) ohne Streifen nicht-ganzzahliger Ordnung dazwischen aufweist.

3. Verfahren nach einem der vorherigen Ansprüche, wobei die kristalline Passivierungsschicht aus Siliciumatomen besteht, die an die Oberfläche der Schicht aus Nitriden von Elementen der Gruppe III gebunden und in einer hexagonalen periodischen Anordnung angeordnet sind, die um 30° in Bezug auf das Netzwerk der Schicht aus Nitriden von Elementen der Gruppe III gedreht ist und einen Gitterparameter aufweist, der $\sqrt{3}$ mal größer ist als der Gitterparameter des Netzwerks der Schicht aus Nitriden von Elementen der Gruppe III.

4. Verfahren nach einem der vorherigen Ansprüche, wobei der Schritt des Abscheidens der kristallinen Passivierungsschicht aus einer Ultrahochvakuumabscheidung besteht.

5. Verfahren nach dem vorherigen Anspruch, wobei der Schritt des Abscheidens der kristallinen Passivierungsschicht aus Molekularstrahlepitaxie-Abscheidung besteht.

6. Verfahren nach dem vorherigen Anspruch, das einen Schritt des Messens der Bedeckungsrate der kristallinen Passivierungsschicht durch Elektronenbeugung mit streifendem Einfall in der [1-100]-Richtung während des Schrittes des Abscheidens der kristallinen Passivierungsschicht umfasst, um ein Beugungsbild der kristallinen Passivierungsschicht zu erhalten, wobei die Dauer des Schrittes des Abscheidens der kristallinen Passivierungsschicht von der Intensität von mindestens einer Beugungslinie nicht ganzzahliger Ordnung eines Beugungsbilds der kristallinen Passivierungsschicht abhängig ist, das durch Elektronenbeugung in der kristallographischen Richtung [1-100] erhalten wird.

7. Verfahren nach dem vorherigen Anspruch, wobei das Beugungsbild der kristallen Schicht in der [1-100]-Richtung Folgendes aufweist:

- einen zentralen Streifen (0, 0) und Streifen ganzzahliger Ordnung (0, -1) und (0, 1),
- zwei Beugungsstreifen nicht-ganzzahliger Ordnung (0, -1/3) und (0, -2/3) zwischen dem zentralen Streifen (0, 0) und dem Streifen ganzzahliger Ordnung (0, -1), und
- zwei Beugungsstreifen nicht-ganzzahliger Ordnung (0, 1/3) und (0, 2/3) zwischen dem zentralen Streifen (0, 0) und dem Streifen ganzzahliger Ordnung (0, 1);

wobei der Schritt des Abscheidens der kristallinen Passivierungsschicht unterbrochen wird, wenn die Lichtintensität der Streifen nicht-ganzzahliger Ordnung maximal ist.

8. Verfahren nach einem der Ansprüche 1 bis 3, wobei der Schritt des Abscheidens der kristallinen Passivierungsschicht aus einer Dampfphasenabscheidung besteht.

9. Verfahren nach dem vorherigen Anspruch, wobei der Schritt des Abscheidens der kristallinen Passivierungsschicht aus einer metallorganischen Gasphasen-Epitaxie-Abscheidung besteht.

10. Verfahren nach einem der vorherigen Ansprüche, wobei die kristalline Passivierungsschicht eine Dicke von weniger als 6 Å aufweist.

11. Verfahren nach einem der vorherigen Ansprüche, das einen Schritt des Bildens (100) einer Pufferschicht (20) auf einem Substrat (10) umfasst, wobei die Pufferschicht (20) die Schicht aus Nitriden von Elementen der Gruppe III umfasst, auf der die kristalline Passivierungsschicht (31) abgeschieden wird.

12. Verfahren nach dem vorherigen Anspruch, wobei die Pufferschicht (20) nach ihrer Bildung eine Dicke zwischen 10 und 200 nm aufweist.

13. Verfahren nach einem der Ansprüche 11 bis 12, wobei das Substrat Siliciumbasiert ist und der Schritt des Bildens (100) der Pufferschicht (20) das Abscheiden (110) einer Schicht aus Aluminiumnitrid AlN (21) einschließt.

14. Verfahren nach dem vorherigen Anspruch, wobei der Schritt des Bildens (100) der Pufferschicht (20) das Abscheiden (120) einer Schicht aus Gallium- und Aluminiumnitrid AlGaN (22) auf der Aluminiumnitridschicht einschließt.

15. Passivierte Halbleiterstruktur, die einen Träger für eine Struktur aus Nitriden von Elementen der Gruppe III bildet, wobei die Halbleiterstruktur eine Schicht aus Nitriden von Elementen der Gruppe III umfasst, deren gesamte Oberfläche von einer kristallinen Passivierungsschicht (31) bedeckt ist, wobei die kristalline Passivierungsschicht durch einen Abscheidungsschritt erhalten werden kann, wobei die kristalline Passivierungsschicht aus Siliciumatomen besteht, die an die Oberfläche gebunden sind, und eine dreifache Periodizität von Siliciumatomen in der kristallographischen Richtung [1-100] aufweist, so dass ein Beugungsbild der kristallinen Passivierungsschicht, das durch Elektronenbeugung mit streifendem Einfall in der Richtung [1-100] erhalten wird, Folgendes umfasst:

- einen zentralen Streifen (0, 0) und Streifen ganzzahliger Ordnung (0, -1) und (0, 1),
- zwei Beugungsstreifen nicht-ganzzahliger Ordnung (0, -1/3) und (0, -2/3) zwischen dem zentralen Streifen (0, 0) und dem Streifen ganzzahliger Ordnung (0, -1), und
- zwei Beugungsstreifen nicht-ganzzahliger Ordnung (0, 1/3) und (0, 2/3) zwischen dem zentralen Streifen (0, 0) und dem Streifen ganzzahliger Ordnung (0, 1);

wobei die Halbleiterstruktur **dadurch gekennzeichnet ist, dass** die Lichtintensität der Zwischenstreifen nicht ganzzahliger Ordnung des Beugungsbildes in Abhängigkeit von der Abscheidungszeit zum Zeitpunkt der Unterbrechung der Abscheidung maximal ist.

16. Struktur nach dem vorherigen Anspruch, wobei die kristalline Schicht eine einfache Periodizität in der kristallographischen Richtung [1-210] aufweist, so dass ein Beugungsbild der kristallinen Passivierungsschicht, das durch Elektronenbeugung mit streifendem Einfall in der [1-210]-Richtung erhalten wird, einen zentralen Streifen (0, 0) und Streifen ganzzahliger Ordnung (0, -1) und (0, 1) ohne Streifen nicht-ganzzahliger Ordnung dazwischen aufweist.

17. Struktur nach einem von Anspruch 15 oder Anspruch 16, wobei die kristalline Passivierungsschicht aus Siliciumatomen besteht, die an die Oberfläche der Schicht aus Nitriden von Elementen der Gruppe III gebunden und in einer hexagonalen periodischen Anordnung angeordnet sind, die um 30° in Bezug auf das Netzwerk der Schicht aus Nitriden von Elementen der Gruppe III gedreht ist und einen Gitterparameter aufweist, der $\sqrt{3}$ mal größer ist als der Gitterparameter des Netzwerks der Schicht aus Nitriden von Elementen der Gruppe III.

18. Struktur nach einem der Ansprüche 15 bis 17, wobei die kristalline Passivierungsschicht eine Dicke von weniger als 0,6 nm aufweist.

19. Struktur nach einem der Ansprüche 15 bis 18, wobei die Schicht aus Nitriden von Elementen der Gruppe III eine selbsttragende Schicht ist.

20. Struktur nach einem der Ansprüche 15 bis 18, das ein Substrat (10) und eine Pufferschicht (20) auf dem Substrat umfasst, wobei die Pufferschicht die Schicht aus Nitriden von Elementen der Gruppe III bildet, deren gesamte Oberfläche kontinuierlich von einer kristallinen Passivierungsschicht (31) bedeckt ist.

21. Struktur nach dem vorherigen Anspruch, wobei die Pufferschicht (20) eine Dicke zwischen 10 und 200 nm aufweist.

22. Struktur nach einem der Ansprüche 20 bis 21, wobei das Substrat (10) Siliciumbasiert ist und die Pufferschicht eine Schicht aus Aluminiumnitrid AlN (21) und ferner eine Schicht aus Gallium- und Aluminiumnitrid AlGaN (22) auf der Aluminiumnitrid-AlN-Schicht (21) umfasst.

23. Struktur nach einem der Ansprüche 20 und 21, wobei das Substrat aus Saphir, Silicium Si, Silizium-auf-Isolator SOI, Siliciumcarbid SiC, Aluminiumnitrid AlN, Zinkoxid ZnO oder Galliumarsenid GaAs besteht.

**Claims**

1. A method for producing a passivated semiconductor support structure for a structure made from group III nitrides, wherein the method comprises a step of deposition (201) of a crystalline passivation layer (31) covering the entire surface of a layer made from group III nitrides of the semiconductor structure, said crystalline passivation layer being deposited from a precursor containing silicon atoms and said crystalline passivation layer (31) being constituted of silicon atoms bound to the surface of the layer made from group III nitrides, the deposition time of said crystalline passivation layer being selected so as to obtain a crystalline layer having a triple periodicity of silicon atoms in the crystallographic direction [1-100] such that a diffraction image of said crystalline passivation layer obtained by grazing-incidence diffraction of electrons in the direction [1-100] comprises:

- a central line (0, 0) and integer order lines (0, -1) and (0, 1),
- two fractional order diffraction lines (0, -1/3) and (0, -2/3) between the central line (0, 0) and the integer order line (0, -1), and
- two fractional order diffraction lines (0, 1/3) and (0, 2/3) between the central line (0, 0) and the integer order line (0, -1);

the method being **characterized in that** the luminous intensity of said fractional order intermediate lines of the diffraction image as a function of said deposition time of said crystalline passivation layer is maximal upon interruption of the deposition.

2. The method according to the preceding claim, wherein the crystalline passivation layer has a single periodicity in the crystallographic direction [1-210] such that a diffraction image of said crystalline passivation layer obtained by grazing-incidence diffraction of electrons in the direction [1-210] has a central line (0, 0) and integer order lines (0, -1) and (0, 1) without fractional order lines between them.

3. The method according to one of the preceding claims, wherein said crystalline passivation layer consists of silicon atoms bound to the surface of the layer made from group III nitrides and arranged in a hexagonal periodical arrangement turned by 30° with respect to the lattice of the group III nitride layer and with a lattice parameter $\sqrt{3}$ times greater than the lattice parameter of the lattice of the made from group III nitride.

4. The method according to one of the preceding claims, wherein the step of deposition of the crystalline passivation layer consists of an ultra-vacuum deposition.

5. The method according to the preceding claim, wherein the step of deposition of the crystalline passivation layer consists of a deposition by molecular beam epitaxy.

6. The method according to the preceding claim, comprising a step of measuring the coverage level of the crystalline passivation layer by grazing-incidence diffraction of electrons in the direction [1-100] during the step of deposition of the crystalline passivation layer so as to obtain a diffraction image of said crystalline passivation layer, wherein the duration of the step of deposition of the crystalline passivation layer is a function of the intensity of at least one fractional order diffraction line of a diffraction image of the crystalline passivation layer obtained by electron diffraction in the crystallographic direction [1-100].

7. The method according to the preceding claim, wherein the diffraction image of the crystalline layer in the direction [1-100] contains:

- a central line (0, 0) and integer order lines (0, -1) and (0, 1),
- two fractional order diffraction lines (0, -1/3) and (0, -2/3) between the central line (0, 0) and the integer order line (0, -1), and
- two fractional order diffraction lines (0, 1/3) and (0, 2/3) between the central line (0, 0) and the integer order line (0, 1).

the step of deposition of the crystalline passivation layer being interrupted when the luminous intensity of said fractional order lines is maximal.

8. The method according to one of claims 1 to 3, wherein the step of deposition of the crystalline passivation layer consists of a vapour phase deposition.

9. The method according to the preceding claim, wherein the step of deposition of the crystalline passivation layer consists of a deposition by metal organic vapour phase epitaxy.

10. The method according to any one of the preceding claims, wherein the crystalline passivation layer has a thickness of less than 6 Å.

11. The method according to any one of the preceding claims, comprising a step of formation (100) on a substrate (10) of a buffer layer (20), said buffer layer (20) comprising the layer made from group III nitrides on which is deposited the crystalline passivation layer (31).

12. The method according to the preceding claim, wherein the buffer layer (20) has, at the end of its formation, a thickness comprised between 10 and 200 nm.

13. The method according to one of the claims 11 to 12, wherein the substrate is silicon-based and the step of formation (100) of the buffer layer (20) includes the deposition (110) of an aluminium nitride AlN layer (21).

**14.** The method according to the preceding claim, wherein the step of formation (100) of the buffer layer (20) includes the deposition (120) of a gallium and aluminium nitride AlGaN layer (22) on the aluminium nitride layer.

**15.** A passivated semiconductor support structure for a structure made from group III nitrides, the semiconductor structure comprising a layer made from group III nitrides, the entire surface of which is entirely covered by a crystalline passivation layer (31), the crystalline passivation layer being obtainable by a step of deposition, the crystalline passivation layer being constituted of silicon atoms bound to the surface and having a triple periodicity of silicon atoms in the crystallographic direction [1-100] such that a diffraction image of said crystalline passivation layer obtained by grazing-incidence diffraction of electrons in the direction [1-100] comprises:

- a central line (0, 0) and integer order lines (0, -1) and (0, 1),
- two fractional order diffraction lines (0, -1/3) and (0, -2/3) between the central line (0, 0) and the integer order line (0, -1), and
- two fractional order diffraction lines (0, 1/3) and (0, 2/3) between the central line (0, 0) and the integer order line (0, -1);

the semiconductor structure being **characterized in that** that the luminous intensity of said fractional order intermediate lines of the diffraction image as a function of the deposition time is maximal upon interruption of the deposition.

**16.** The structure according to the preceding claim, wherein the crystalline layer has a single periodicity in the crystallographic direction [1-210] such that a diffraction image of said crystalline passivation layer obtained by grazing-incidence diffraction of electrons in the direction [1-210] contains a central line (0, 0) and integer order lines (0, -1) and (0, 1) without fractional order lines between them.

**17.** The structure according to one of claim 15 or claim 16, wherein said crystalline passivation layer consists of silicon atoms bound to the surface of the layer made from group III nitrides and arranged in a hexagonal periodical arrangement turned by 30° with respect to a lattice of the layer made from group III nitride and with a lattice parameter $\sqrt{3}$ times greater than the lattice parameter of the lattice of the layer made from group III nitride.

**18.** The structure according to one of claims 15 to 17, wherein the crystalline passivation layer has a thickness of less than 0.6 nm.

**19.** The structure according to one of claims 15 to 18, wherein the layer made from group III nitrides is a self-supporting layer.

**20.** The structure according to one of claims 15 to 18, comprising a substrate (10) and a buffer layer (20) on the substrate, the buffer layer constituting the layer made from group III nitrides, the entire surface of which is continuously covered by a crystalline passivation layer (31).

**21.** The structure according to the preceding claim, wherein the buffer layer (20) has a thickness comprised between 10 and 200 nm.

**22.** The structure according to one of claims 20 to 21, wherein the substrate (10) is silicon-based and the buffer layer comprises an aluminium nitride AlN layer (21) and further a gallium and aluminium nitride AlGaN layer (22) on the aluminium nitride AlN layer (21).

**23.** The structure according to one of claims 20 to 21, wherein the substrate is made from sapphire, silicon Si, silicon on insulator SOI, silicon carbide SiC, aluminium nitride AlN, zinc oxide ZnO or gallium arsenide GaAs.

**FIG 1**

Formation d'une
Couche tampon

100

Dépôt d'une couche
d'AlN

110

Dépôt d'une couche
d'AlGaN

120

Dépôt d'une couche de
passivation 1x3

201

**FIG 2**

31

22
20
21

AlGaN

AlN

Substrat

10

**FIG 3**

**FIG 4**

## FIG 5

31

20 { 22
     21

11

AlGaN

AlN

Substrat

10

## FIG 6

12

31

20 { 22
     21

AlGaN

AlN

10

## FIG 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 10151092 A1
- WO 2007133603 A2

**Littérature non-brevet citée dans la description**

- **SAKAI et al.** A New Method of Reducing Dislocation Density in GaN Layer Grown on Sapphire Substrate by MOVPE. *J. Cryst. Growth,* 2000, vol. 221, 334
- **S. TANAKA et al.** Anti-Surfactant in III-Nitride Epitaxy - Quantum Dot Formation and Dislocation Termination. *Jap. J. Appl. Phys.,* 2000, vol. 39, L831
- **F. YUN et al.** Efficacy of single and double SiNx interlayers on defect reduction in GaN overlayers grown by organometallic vapor-phase epitaxy. *J. Appl. Phys.,* 2005, vol. 98, 123502
- **T. MARKURT et al.** Blocking Growth by Electrically Active Subsurface Layer : The Effects of Si as an Antisurfactant in the Growth of GaN. *Physical Review Letters,* 2013, vol. 110, 036103
- **AYAHIKO ICHIMIYA ; PHILIP I. COHEN.** Reflection High Energy Electron Diffraction. Cambridge University Press, 2004